**Europäisches Patentamt**

**European Patent Office**

**Office européen des brevets**

(19)

(11). Veröffentlichungsnummer : **0 075 537 B2**

(12) # NEUE EUROPÄISCHE PATENTSCHRIFT

(45) Veröffentlichungstag der neuen Patentschrift :
**20.03.91 Patentblatt 91/12**

(51) Int. Cl.⁵ : **G03F 7/004, G03F 7/26,
H05K 3/28, H01L 21/312,
H01L 21/47**

(21) Anmeldenummer : **82810383.8**

(22) Anmeldetag : **13.09.82**

(54) **Verfahren zum Beschichten gedruckter Schaltungen.**

Die Akte enthält technische Angaben, die nach dem Eingang der Anmeldung eingereicht wurden und die nicht in dieser Patentschrift enthalten sind.

(30) Priorität : **17.09.81 CH 6007/81**

(43) Veröffentlichungstag der Anmeldung :
**30.03.83 Patentblatt 83/13**

(45) Bekanntmachung des Hinweises auf die Patenterteilung :
**07.08.85 Patentblatt 85/32**

(45) Bekanntmachung des Hinweises auf die Entscheidung über den Einspruch :
**20.03.91 Patentblatt 91/12**

(84) Benannte Vertragsstaaten :
**AT BE CH DE FR GB IT LI NL SE**

(56) Entgegenhaltungen :
**EP-A- 0 002 040
EP-A- 0 008 837
AT-B- 353 368**

(56) Entgegenhaltungen :
**FR-A- 2 445 624
GB-A- 2 032 939
US-A- 4 230 793
Ullmanns Encyklopädie der technischen Chemie (1960), Band 11, "Lacke", S. 81, Z. 1-7 und S. 361, Beispiel 2**

(73) Patentinhaber : **CIBA-GEIGY AG
Klybeckstrasse 141
CH-4002 Basel (CH)**

(72) Erfinder : **Audykowski, Thaddeus, Dr.
Im Langen Loh 68
CH-4123 Allschwil (CH)**
Erfinder : **Mentha, Anton
Lochstrasse 9
CH-5304 Endingen (CH)**
Erfinder : **Losert, Ewald
Habsburgerstrasse 30
CH-4310 Rheinfelden (CH)**

(74) Vertreter : **Zumstein, Fritz jun., Dr. et al
Dr. F. Zumstein sen. Dr. E. Assmann Dr. R. Koenigsberger Dipl.-Ing. F. Klingseisen Dr. F. Zumstein jun. Bräuhausstrasse 4
W-8000 München 2 (DE)**

**EP 0 075 537 B2**

## Beschreibung

Die vorliegende Erfindung betrifft ein Verfahren zur Herstellung von schutzmarken auf gedruckte Schaltugen.

Bei der Herstellung von gedruckten Schaltungen ist es üblich, die Leiterzüge zum Schutz vor äusseren Einflüssen mit einer dünnen Isolations- und Schutzschicht zu versehen, Diese Schichten dienen oft gleichzeitig als Lötstoppmasken, um bei späteren Lötverfahren einen unerwünschten Kantakt der Leiterzüge zu verhindern. Als Beschichtungsverfahren hat sich zum Aufbringen der dünnen Schichten besonders das Vorhanggiessverfahren bewährt. Letzteres ist zum Beispiel in der US-PS 4 230 793 beschrieben.

An die lichtempfindlichen Lacke werden hohe Anforderungen gestellt. Sie müssen eine hohe Bildauflösung und Entwickelbarkeit, eine gute Haftung auf dem Leitermetall und auf Kunstharzen, sowie eine hohe thermische, mechanische, elektrische und chemische Resistenz haben. Zur Erzielung solcher Eigenschaften muss eine weitgehend gleichmässige Dicke der Schutzschicht erreicht werden, die frei von Poren und Blasen ist. Die Erreichung gleichmässiger Schichtdicken unter Erhaltung der gewünschten Eigenschaften hat sich beim Vorhanggiessverfahren in der Praxis als nur teilweise gelöstes Problem erwiesen. Wenn der Lack eine zu hohe Viskosität und damit zu geringe Fliessfähigkeit aufweist, ist die Benetzung zwischen den Leiterzügen besonders bei geringen Abständen (Feinleitertechnik) ungenügend und damit auch die Haftung zu gering. Bei einer niedrigen Viskosität des Lackes beobachtet man eine zu geringe Bedeckung an den Kanten der Leiterzüge, die durch das Fliessen der Schicht nach dem Aufbringen verursacht wird (Kantenflucht). Hierdurch wird die Schutzfunktion der Schicht beeinträchtigt.

So hat sich in der Praxis gezeigt, dass z. B. die Lötstopplacke nicht ganz den Anfarderungen beim Lötvorgang genügen, wobei eine Schutzmaske Temperaturen von z. B. 270°C während 10 Sekunden schadlos überstehen muss. Werden scharfe Fluxmittel eingesetzt, werden die Ausschussraten noch zusätzlich erhöht. Dies ist ein erheblicher wirtschaftlicher Nachteil, weil schadhafte Teile erst am Ende der Fertigung entstehen. Ein nach nicht zufriedenstellend gelöstes Problem ist ferner die zu geringe Haftfestigkeit solcher Beschichtungsmittel auf Blei/Zinn-Legierungen.

Aus der GB-A-2 032 939 sind lichtempfindliche Beschichtungsmittel bekannt, die feinteilige Füllstoffe und als lichtempfindliche Substanz Umsetzungsprodukte von Polyepoxiden mit äthylenisch ungesättigten Carbonsäuren enthalten. Diese Beschichtungsmittel werden vorwiegend als Siebdrucktinten mit relativ hoher Viskosität eingesetzt. Ihre Verwendung im Vorhanggiessverfahren wird auch erwähnt. Die lichtempfindliche Subtanz ist ein Thermoplast. Eigene Untersuchugen haben ergeben, dass mit diesen Beschichtungsmitteln im Vorhanggiessverfahren keine einwandfreien Beschichtungen hergestellt werden können, die der Praxis genügen. So neigen aufgebrachte Schichten bereits beim Trocknen zur Bildung von Fehlstollen infolge Thermoplastizität. Die Beständigkeit beim Lötvorgang ist wegen Versprödung und Haftverlust zu gering, um die Probleme der Praxis zu lösen.

Die FR-A-2445624 offenbart ein Verfahren zum Erzeugen von Passivierschichten auf Substraten, besondern Siliziumplättchen, unter Verwendung von Polyisopren-Photoresist-Polymeren und Glaspulver als Füllstoff. Während des Entwickelns der belichteten Schicht wird die Entwickler-Losüng mit Ultraschall behandelt.

Aufgabe vorliegender Erfindung ist es, ein Verfahren unter Benutzung eines lichtempfindliches Beschichtungsmittel bereitzustellen, mit dem beim Vorhanggiessverfahren eine gleichmässige Beschichtung auf Leiterplatten mit guter Kantendeckun auch bei niedrigerer Viskosität erzielt werden kann, das eine verbesserte Haftung auf Blei/Zinn-Leierungen aufweist sowie eine erhöhte Beständigkeit beim Lötvorgangauch bei Verwendung schärferer Fluxmittel, um die Ausschussraten zu vermindern.

Gegenstand vorliegender Erfindung ist ein Verfahren zur Herstellung von Schutendsken durch Aufbrigen eines dunnen Schicht eines Berchichtungmittels auf eine gedruckte Schuttung nach dem Vorhanggiessverfahren, nach folgende Trocknung, bildamässige Belichtung unter Aussparung der Lötstellen, anschliessende Entwicklung der nicht belichteten Bereiche mit einem Lösungsmittel und nachfolgende Aushärtung, wobei ein Beschichtungsmittel mit einer Viskosität von 200 bis 700 m Pas bei 25°C aus einer Lösung einer lichtempfindlichen und thermish härbaren lackbilden Substanz verwendet wird, das dadurch gekennzeichnet ist, dass in der Lösung 10 bis 50 Gew.%, bezogen auf die lichtempfindliche Verbindung, eines feinteiligen Füllstoffes gleichmässig verteilt sind, die lichtempfindliche und thermisch härtbare Substanz ein lichtempfindliches und thermisch härtbares Epoxidharz ist und die Lösung zusätzlich einen Härter enthält.

Die lichtempfindlichen Epoxidharze weisen freie härtbare Epoxidgruppen auf und werden definitionsgemäss zusammen mit einem üblichen Härter und geebenenfalls einem Härtungsbeschleuniger eingesetzt. Die lichtempfindliche Gruppe ist bevorzugt eine äthylenisch ungesättigte Gruppe, die z. B. als Seitengruppe, wie z. B. ein Zimtsäurerest, oder in einer Molekülkette, wie z. B. die Chalkongruppe, gebunden sein kann. Bei den Epoxidharzon kann es sich um Monomere handeln oder bevorzugt um vorreagierte Addukte mit üblichon Härtern, wie Polyaminen, Polycarbonsäuren, Polyalkoholen und Polyphenolen. Die don Substanzen zugrundeliegenden Epoxidharze können auf der Basis von Bisphenollen, wie Bisphenol A, Novolaken, Hydantoinen, Uracilen und Isocyanuraten aufgebaut sein.

Bevorzugt sind Epoxidharze mit Chalkongruppen als lichtempfindliche und thermohärtbare substanzen. Chalkongruppen enthaltende Verbindungen, die sich für den Aufbau solcher Epoxidharze eignen, sind z. B. 4.4'-Dihydroxydistyrylketon, Bis(p-hydroxy-benzoylvinyl)-phenylen oder p-Hydroxyphenyl-p-hydroxystyrylketon. Für das erfindungsgemässe Beschichtungsmittel geeignete lichtempfindliche thermohärtbare Substanzen sind z. B. in der DE-OS 23 42 407 beschrieben.

Bei den erfindungsgemässen Beschichtungsmitteln kann es sich je nach Art der verwendeten photopolymerisierbaren Substanz um wässrige, gegebenenfalls alkalisch oder sauer eingestellte, oder um organische Lösungen handeln. Geeignete Lösungsmittel, die alleine oder in Gemischen eingesetzt werden können, sind z. B.: Ketone, wie Dimethylketon, Diäthylketon, Methylisobutylketon, Cyclohexanon, Cyclopentanon, Cycloheptanon, Isophoron, Methoxyhexanon, Acetonylaceton, Acetophenon, Benzyläthylketon, 3,3,5-Trimethylcyclohexanon, Mesityloxid; halogenierte Kohlenwasserstoffe wie Tetrachlorkohlenstoff, Chloroform, Methylenchlorid, Methylenbromid, Bromchlormethan, 1,2-dichloräthan, 1,1,2-Trichloräthan, 1,1,2,2-Tetrachloräthan, 1,2,3-Trichlorprapan, Perchloräthylen; Alkohole wie Methanol, Aethanol, Propanol, Butanol, Hexanol, Cyclohexanol, Furfurylalkohol, Tetrahydrofurfurylakohol, Benzylalkohol, monoalkylierte Glykole wie Methylglykol, Aethylglykol, Aethyldiglykol, Triäthylenglykomonoäthyl- oder -monobutyläther, Glykole wie Aethylen-, Propylen- oder Butylenglykol und deren Oligomere wie Triäthylenglykol; aliphatische und aromatische Kohlenwasserstoffe wie Pentan, Hexan, Cyclohexan, Methylcyclohexan, Benzol, Toluol oder Xylol, Aether wie Diäthyläther, Dibutyläther, Tetrahydrofuran, Dioxan, Aethylenglykoldimethyläther, Diäthylenglykoldimethyläther, Carbonsäureester wie Methyl-, Aethyl-, Propyl-, Butyl- und Isopropylsowie Phenylacetat, Propionsäuremethylester, Glykolsäurebutylester, Benzoesäuremethylester, Aethylglykolmono- oder -diacetat, Methyl- oder Aethylglycalsäureacetat; Lactone wie Butyro-, Valerolacton; Säureamide wie Dimethylformamid, Dimethylacetamid, Hexamethylphosphorsäuretriamid; Sulfone wie z. B. Dimethylsulfon, Dibutylsulfon oder Tetramethylensulfon.

Die Menge des verwendeten Lösungsmittels richtet sich im wesentlichen nach der gewünschten Viskosität des Beschichtungsmittels, die bevorzugt zwischen 200 und 500, insbesondere 300 und 450 m Pas beträgt.

Die Menge des Füllstoffes beträgt bevorzugt 10 bis 30 Gew.%, besonders 15 bis 25 Gew.%. Ferner kann der Füllstoff eine spezifische Oberfläche von mindestens 10 m²/g, besonders mindestens 100 m²/g aufweisen. Je nach Füllstoff kann die spezifische Oberfläche bis zu 500 m²/g und mehr betragen.

Die Partikelgrösse des Füllstoffes soll kleiner gewählt werden als der Abstand von Leiterzügen in gedruckten Schaltungen. Die mittlere Partikelgrösse kann 0,01 bis 10 μm, vorzugsweise 0,01 bis 5 μm betragen. Besonders bevorzugt sind mikronisierte Füllstoffe, die im allgemeinen eine mittlere Partikelgrässe von 0,01 bis 1,5 μm aufweisen.

Geeignete Füllstoffe sind beispielsweise kolloidales oder hydrophobiertes Siliziumdioxid, Mikrotalkum, Mikroglimmer, Kaolin, Aluminiumaxide, Aluminiumhydroxyd, Calciumsilikat, Aluminiumsilikat, Magnesiumcarbonat, Calciumcarbonat, Zirkoniumsilikat, Porzellanmehl, Antimontrioxid, Titandioxid, Bariumtitanat oder Bariumsulfat oder Gemische der genannten Füllstoffe.

Besonders bevorzugte Füllstoffe sind kalloidales Siliziumoxid, Mikratalkum, Aluminiumoxid, Antimonoxid und chamotisiertes Kaolin. Die Füllstoffe sind vorteilhaft mit einem Haftvermittler versehen, um eine enge Haftung zwischen Polymermatrix und Füllstoff zu erzielen. Uebliche Haftvermittler sind z. B. Trialkoxysilane, die funktionelle Gruppen wie z. B. OH, NH$_2$, Epoxid- oder Vinylgruppen enthalten. Beispiele sind Trialkoxysily-γ-glycidoxy- oder -γ-aminopropan und Trialkoxyvinyl- oder -allylsilan. Die Alkoxygruppe kann 1 bis 12 C-Atome enthalten und z. B. Methyl, Aethyl, Propyl, Butyl, hexyl, Octyl oder Dodecyl sein.

Besonders vorteilhaft enthält das erfindungsgemässe Beschichtungsmittel mindestens 10 Gew.-% Mikrotalkum entweder alleine oder in Kombination mit anderen Füllstoffen, wobei mindestens die Hälfte der Gesamtfüllstoffmenge Mikrotalkum ist. Es wurde gefunden, dass die Haftung der Schicht auf den Leiterplatten und Blei/Zinn-Legierung hierdurch besonders verbessert wird.

Das Beschichtungsmittel kann weitere übliche Zusätze enthalten, wie z. B. Verlaufmittel, Farbstoffe, Pigmente, Stabilisatoren, Flammschutzmittel, Photosensibilisatoren oder -aktivatoren, Härter und Härtungs beschleuniger. Als vorteilhaft hat sich der Zusatz von 1 bis 5 Gew.% Polyäthylen, bezogen auf die photopolymerisierbare Substanz, erwiesen. Es wurde gefunden, dass hierdurch die Blasenbildung besonders entlang von Leiterzügen und um Bohrungen vollständig verhindert wird.

Besonders zweckmässig ist der Zusatz von Antiabsetzmitteln zur Erhöhung der Lagerstabilität der erfindungsgemässen Beschichtungsmittel und zum Erhalt der Verarbeitbarkeit. Hiermit wird vermieden, dass der Füllstoff sich absetzt und daher vor der Verarbeitung erneut gleichmässig verteilt werden muss. Das Antiabsetzmittel kann in Mengen von 0,1-3 Gew.% zugegeben werden, bezogen auf den Füllstoff. Beispiele für solche Mittel sind Montmorillonit, Bentone, Asbest und Xonolith.

Die erfindungsgemässen Beschichtungsmittel können durch Vormischen einzelner Bestandteile und darauffolgendes Zusammengeben oder durch das Vermischen der Einzelbestandteile in hierfür üblichen Einrichtungen wie Rührergefässen, die ein gleichmässiges Vermischen gestatten, hergestellt werden. Es hat sich als vorteilhaft erwiesen, die Füllstoffe zunächst in einem geeigneten Medium zu dispergieren, z. B. in hydroxylgruppenhaltigen Polyesternharzen und/oder Lösungsmitteln, und so gegebenenfalls unter Zusatz eines Haftvermittlers zu Pasten zu verarbeiten, die eine zu lange und u. U. für die lichtempfindlichen Substanzen schädliche Dispergierzeit vermeiden. Solche Pasten können beispielsweise in Kugelmühlen, Highspeed-Dissolvern oder Walzenmahlmaschinen hergestellt werden.

Die erfindungsgemässen Beschichtungsmittel eignen sich hervorragend zur Herstellung von isolations- und Schutzüberzügen und besonders zur Herstellung von Lötstoppmasken und Galvanoresists auf gedruckten Schaltungen. Es werden poren- und blasenfreie, gleichmässige Beschichtungen mit guter Haftung selbst bei geringen Leiterabständen (< 200 µm) erzielt. Die Kantenflucht ist vermindert ; die Schichtdicke über den Kanten kann 50% und mehr der Gesamtschichtdicke betragen, wobei diese im allgemeinen im Bereich von 5 bis 50 µm, besonders 10 bis 30 µm liegt. Eine verbesserte Haftfestigkeit wird auf Metallen wie Biezinn und Zinn vor und nach dem Löten gefunden. Die Füllstoffe erzeugen eine seidenglänzende bis matte Oberfläche, wodurch die visuelle Qualitätskontrolle erleichtert wird.

Nach dem Aufbringen der Schicht auf die gedruckte Schaltungen wird das Lösungsmittel unter Erwärmen zur Erzeugung klebfreier Schichten für die weitere Verarbeitung in Oefen (z. B. Durchlaufofen) entfernt. Hierauf wird das beschichtete Substrat gegebenenfalls durch eine Bildmaske belichtet (UV-Strahlen) und danach mit einem Lösungsmittel entwickelt, um die metallischen Teile von Löststellen vom Polymer zu befreien. Das Aufbringen der Füllstoffhaltigen Beschichtungsmittel erfolgt ohne dass vorhandene Bohrstellen verstopft werden, so dass Polymerreste bei der Entwicklung vollständig entfernt werden. Darauf Können die Filme bei höheren Temperaturen von z. B. 80 bis 160°C ausgehärtet werden. Die erhaltenen gedruckten Schaltungen weisen Schutzschichten auf, die die an sie gestellten Anforderungen erfüllen. Die elektrischen Eigenschaften sind nicht vermindert und die Beständigkeit auf dem Lötbad ist erheblich verbessert, so dass sogar mehrere Zyklen auf dem Lötbad möglich sind.

Das Vofhanggiessverfaren kann wie folgt durchgeführt werder. Man erzeugt bei Raumtemperatur einen dünnen fliessenden Vorhang des Beschichtujngsmittels durch Auspressen aus einem Spalt, wobei die Viskosität des Beschichtungsmittels bevorzugt zwischen 200 und 500 m Pas beträgt. Die Fliessgeschwindigkeit des Vorhanges wird so gewählt, dass sie beim auftreffen auf die Platte 60-160, besonders 70-120 m/min beträgt. Die zu beschichtende Platte wird vorteilhaft vorerwärmt, z. B. auf 60 bis 100°C. Die Platte wird mit einer Geschwindigkeit durch den fliessenden Vorhang geführt, die etwa gleich und bevorzugt grösser ist als die Fliessgeschwindigkeit des Vorhanges. Nach der Beschichtung wird das Lösungsmittel langsam (Ablufttrocknung im Durch laufofen) entfernt, um eine Blasenbildung zu vermeiden, die Platte belichtet, entwickelt und danach die Schutzschicht thermisch gehärtet.

Die nachfolgenden Beispiele erläutern die Erfindung, Teile sind hierin Gew.-Teile.

Beispiel 1

1500 Teile einer ca. 50%igen Lösung eines Lichtempfindlichen Epoxidharzes aus Bis-1,3-(4- glycidylaxybenzal) aceton, Bisphenol-A und Tetrabrombisphenol-A vom Molekulargewicht 3000-3500 und einem Epoxidgehalt von 0,8-1,0 Aequivalent/kg werden mit 400 Teilen einer 1 : 1 -Mischung von Cyclohexanon/Methylglykol verdünnt, darauf 484 Teile Siliziumdioxid enthaltende Paste portionsweise zugegeben und 10 Minuten gerührt und dann mit 180 Teilen Härter auf Basis 2,6-Xylylguanid (11%ige Lösung in Methylglykol) versetzt.

Das Beschichtungsmittel hat eine Viskosität von 380 m Pas bei 24°C und einen Festkörpergehalt von 40 Gew.%. Bei der Beschichtung nach dem Vorhanggiessverfahren erhält man eine fehlerfreie, gleichmässige Beschichtung einer gedruckten Schaltung und eine gute Kantenabdeckung der Leiterzüge.

Die Siliziumdioxid enthaltende Paste wird folgendermassen erhalten :

5634 Teile Cyclohexanon werden mit 33 Teilen γ-Glycidoxypropyltrimethoxysilan und 1750 Teilen einer 20%igen Polyäthylendispersion gemischt. In diese Mischung werden 840 Teile Siliziumdioxid mit einer mittleren Partikelgrösse von 3-4 µm, 30 Teile Bentone und 33 Teile deionisiertes Wasser bei einer Temperatur von 130°C eingerührt, bis eine gutfliessende Konsistenz erreicht ist. Nach Abkühien auf 30°C werden 1680 Teile der Epoxidharzlösung eingerührt und die Mischung in einer Koruma-Mühle gemahlen.

Beispiel 2

234 Teile Methylglykol, 78 Teile hydroxylgruppenhaltiges Polyesterharz (Vesturit BL 914) und 3,8 Teile γ-Aminopropyltrimethoxysilan werden in einem Highspeed-Dissolver gerührt, 188 Teile Talkum mit einer mittleren Partikelgrösse von 2-3 µm zugegeben und 10 Minuten dispergiert. Vor Verwendung wird die Talkumpaste 24 Stunden stehen gelassen.

1284 Teile Epoxidharzlösung gemäss Beispiel 1 werden mit 276 Teilen Methylglykol verdünnt, unter Rühren 435 Teile der Talkumpaste portionsweise zugegeben und nach 10 Minuten Rühren 154 Teile 2,6- Xylylabiguanid-Lösung zugegeben und darauf mit 100 Teilen Methylglykol verdünnt.

Das Beschichtungsmittel hat eine Viskosität von 380 m Pas bei 24°C und einen Festkörpergehalt von 39,5%. Beim Aufbringen einer Lötstoppmaske nach dem Vorhanggiessverfahren wird eine fehlerfreie gleichmässige Beschichtung mit guter Kantendeckung erhalten.

Beispiel 3

3000 Teile Epoxidharzlösung gemäss Beispiel 1 werden mit 1000 Teilen Cyclohexanon verdünnt und unter Rühren 1125 Teile einer 33%igen Aluminiumoxidpaste (mittlere Partikelgrösse 0.02 µm) in einem 1 : 1-Gemisch aus Methylglykol/Cyclohexanon portionsweise zugegeben. Danach werden nach 360 Teile 2,6-Xylylbiguanid-Lösung eingemischt.

Die Viskosität des Beschichtungsmitels beträgt 280 m Pas bei 25,7°C und der Festkörpergehalt beträgt 34,8%. Der Füllstoffgehalt ist bezogen auf das Bindemittel 24 Gew.%. Nach dem Vorhanggiessverfahren beschichtete gedruckte Schaltungen sind fehlerfrei und weisen eine gute Kantenabdeckung auf.

Beispiel 4

2000 Teile Epoxidharzlösung gemäss Beispiel 1 werden mit 850 Teilen einer 1 : 1-Mischung aus Methylglykol/Cyclohexanon verdünnt und dann 850 Teile einer 33%igen Antimonoxidpaste (mittlere Partikelgrösse < 1 µm) in einer 1 : 1-Mischung aus Methylglykol/Cyclohexanon portionsweise zugegeben. Nach 1O-minütigem Rühren werden noch 240 Teile 2,6-Xylylbiguanid-Lösung verteilt.

Das erhaltene Beschichtungsmittel hat eine Viskosität von 245 m Pas bei 24,5°C und einen Festkörpergehalt von 33 Gew.%. Das Aufbringen von Lötstoppmasken ergibt fehlerfreie gleichmässige Beschichtungen mit guter Kantendeckung.

Beispiel 5

Aus 234 Teilen Methylglykol, 78 Teilen hydroxylgruppenhaltigen Polyesterharz, 3,8 Teilen y- Aminopropyltriäthoxysilan, 180 Teilen Kaolin (mittlere Teilchengrösse 3 µm) und 25 Teilen Siliziumdioxid (Syloid 161) wird in einem Highspeed-Dissolver mittels Dispergierung während 10 Minuten eine Paste hergestellt. Vor Verwendung erfolgt eine 24-stündige Lagerung.

1284 Teile Epoxidharzlösung gemäss Beispiel 1 werden mit 275 Teilen Methylglykol verdünnt. Darauf werden unter Rühren 435 Teile der Kaolinpaste portionsweise zugegeben und 10 Minuten weitergerührt. Danach werden noch 163 Teile 2,6-Xylylbiguanid-Lösung verteilt.

Das erhaltene Beschichtungsmittel hat eine Viskosität von 350 m Pas bei 25°C und einen Festkörpergehalt von 41,8 Gew.%. Die Beschichtung nach dem Vorhanggiessverfahren ergibt tehierfreie gleichmässig beschichtete gedruckte Schaltungen mit guter Kantenabdeckung.

Die Beschichtungen erfolgen auf einer Bürkle-Probimer-150-Maschine unter folgenden Bedingungen : Giess-Spalt : 0,5 mm, Pumpendruck 3,4 bar, Temperatur des Beschichtungsmittels 24,4°C, Viskosität 300 m Pas, Transportgeschwindigkeit 90 m/min, Trocknen 30 min bei 80°C, Belichten 2×5000 W/60 sec, Entwickeln mit Cyclohexanon bei 22-24°C für je 60 sec in zwei Kammern.

Beispiel 6

4000 Teile ca. 50%igen Lösung eines Lichtempfindlichen Epoxidharzes vom Molekulargewicht 3000-3500 und einem Epoxidgehalt von 0,8-1,0 Aeq./kg werden mit 800 Teilen einer 1 : 1 Mischung von Cyclohexanon/Methylglykol verdünnt, darauf 1792 Teile Mikrotalkum enthaltende Paste portionenweise zugegeben und 10 Minuten gerührt, dann mit 645 Teilen Härter auf Basis von Dicyandiamid und Chlortoluron als Beschleuniger (9,5%ige Lösung in Methylglykol) versetzt.

Das Beschichtungsmittel hat eine Viskosität von 435 m Pas bei 24°C und einen Festkörpergehalt von 35 Gew.%. Der Gehalt an Talkum pro Festkörper des Lackes beträgt 21%. Bei der Beschichtung nach dem Vorhanggiessverfahren erhält man eine fehlerfreie, gleichmässige Beschichtung von Gedruckten Schaltunoen und eine sehr gute Kantenabdeckung der Leiterzüge (s. Tabelle 1.).

Die Mikrotalkumpaste wird folgendermassen hergestellt.

In einem geschlossenen vor Lichtstrahlen mit UV-Filtern abgeschirmtem Kessel werden 250 kg Cyclohexanon, 240 kg Methylylglykol, 6 kg SILAN-A-187 und 4 kg deionisiertes Wasser gemischt. Dann werden 330 kg Mikrotalkum (mittlere Partikelgrösse 1,5 µm) und 5 kg Bentone 27 portionenweise eingerührt. Zum Schluss rührt man 165 kg der eingangs erwähnten lichtempfindlichen Epoxidharzlösung ein und lässt diese Suspension während ca. 10 Stunden durch Dyno-Mill mit 12,5 Liter Glaskugeln Durchmesser 1,5-1,5 mm dispergieren, wobei die Suspension mittels einer Umwälzpumpe das Mahlagregat mehrmals durchläuft. Die Temperatur der Mischung übersteigt bei diesem Kreislaufmahlen nicht 85°C, was durch ein an Dyno-Mill angeschlossenes Kühlsystem gesteuert wird.

Die durch Verwendung von Füllstoffpasten erreichte Verbesserung der Kantenabdeckung wird an Schliffkörpern von in Epoxidharz eingebetteten Leiterzügen unter dem Mikroskop ausgemessen. Die Resultate sind in der Tabelle 1 zusammengestellt. Daraus ist deutlich die Tendenz zur gleichmässigeren Schichtdickenverteilung über die Mitte und Kanten von Leiterzügen verschiedener Breite bei mit Füllstoffen modifizierten Beschichtungsmitteln ersichtlich. Vor allem ist aber die Filmdicke an den Kanten viel höher als bei ungefüllten Beschichtungsmitteln.

Ferner zeigte sich, dass diese mit Mikrotalkum gefüllte Formulierungen einen 3-fachen Zyklus von 10 sec./270°C auf dem Lötbad schadlos aushalten im Vergleich zu ungefüllten Beschichtungsmitteln, die sich meistens nur Ix bei dieser Beanspruchung bewähren. Bei einem anderem Test mit schärferen Fluxmitteln kann die Ausschussrate von 30% auf 0% herabgesenkt werden.

Die Güte der Haftfestigkeit auf Blei/Zinn gemessen nach DIN 53151 wird von Gt 4 auf GT 0 heraufgesetzt.

## Tabelle 1

### Schichtdickenverteilung über Leiterzügen

| Leiterhöhe in µm | 70 | | 55 | | 70 | | 70 | | 70 | |
|---|---|---|---|---|---|---|---|---|---|---|
| Füllstoff | Mikrotalkum (1,5 µm) | | Mikrotalkum (1,5 µm) | | Mikrotalkum/$Al_2O_3$ (0,02 µm) (3:1) | | Mikrotalkum/$Al_2O_3$ (1:1) | | — (Vergleich) | |
| Schichtendicken-verteilung*) | Mitte | linke rechte Kante | Mitte | linke rechte Kante | Mitte | linke rechte Kante | Mitte | linke rechte Kante | Mitte | linke rechte Kante |
| Leiterbreite in mu | | | | | | | | | | |
| 60 | 54 | 24/32 | 40 | 23/26 | 42 | 33/11,5 | 36 | 20/30 | | |
| 140 | | | | | | | | | 60 | 16/7 |
| 200 | | | | | | | | | 35-90 | 8/5 |
| 240 | 68,5 | 32/39 | 56 | · 29/31 | 51 | 25/28 | 45 | 20/21 | | |
| 400 | | | 56 | 31/33 | | | | | | |
| 600 | | | | | | | | | 70 | 17/27 |
| 700 | 66 | 32/32 | 71 | 38/35 | 57 | 28/31 | 64 | 34/39 | | |

*) Filmdicke in %, bezogen auf die Laminatfilmdicke als 100 %

EP 0 075 537 B2

## Ansprüche

1. Verfahren zur Herstellung von Schutzmasken durch Aufbringen einer dünnen Schicht eines Beschichtungsmittels auf eine gedruckte Schaltung nach dem Vorhanggießverfahren, nachfolgende Trocknung, bildmäßige Belichtung unter Aussparung der Lötstellen, anschließende Entwicklung der nicht belichteten Bereiche mit einem Lösungsmittel und nachfolgende Aushärtung, wobei ein Beschichtungsmittel mit einer Viskosität von 200 bis 700 mPas bei 25°C aus einer Lösung einer lichtempfindlichen und thermisch härtbaren lackbildenden Substanz verwendet wird, dadurch gekennzeichnet, daß in der Lösung 10 bis 50 Gew.-%, bezogen auf die lichtempfindliche Substanz, eines feinteiligen Füllstoffes gleichmäßig verteilt sind, die lichtempfindliche und thermisch härtbare Substanz ein lichtempfindliches und thermisch härtbares Epoxidharz ist und die Lösung zusätzlich einen Härter enthält.

2. Verfahren gemäß Anspruch 1, dadurch gekennzeichnet, daß die Viskosität des Beschichtungsmittels zwischen 200 und 500 mPas beträgt.

3. Verfahren gemaß Anspruch 1, dadurch gekennzeichner, daß das Beschichtungsmittel ein organisches Lösungsmittel enthält.

4. Verfahren gemäß Anspruch 1, dadurch gekennzeichnet, daß das Beschichtungsmittel 10 bis 30 Gew.-% des Füllstoffes enthält.

5. Verfahren gemäß Anspruch 1, dadurch gekennzeichnet, daß das Beschichtungsmittel einen Füllstoff mit einer mittleren Partikelgröße von 0,01 bis 10 μm enthält.

6. Verfahren gemäß Anspruch 1, dadurch gekennzeichnet, daß das Beschichtungsmittel als füllstoff einen mikronisierten Füllstoff mit einer mittleren Partikelgröße von 0,01 bis 1,5 μm enthält.

7. Verfahren gemäß Anspruch 1, dadurch gekennzeichnet, daß das Beschichtungsmittel als Füllstoff feinteiliges Siliziumdioxid, Mikrotalkum, Mikroglimmer, Kaolin, Aluminiumoxide, Aluminiumhydroxyd, Calciumsilikat, Aluminiumsilikat,

Magnesiumcarbonat, Calciumcarbonat, Zirkoniumsilikat, Porzellanmehl, Antimontrioxid, Titandioxid, Bariumtitanat oder Bariumsulfat oder Gemische dieser Füllstoffe enthält.

8. Verfahren gemäß Anspruch 1, dadurch gekennzeichnet, daß das Beschichtungsmittel mindestens 10 Gew.-% Mikrotalkum entweder alleine oder im Gemisch mit weiteren feinteiligen Füllstoffen enthält, wobei mindestens die Hälfte der Gesamtfüllstoffmenge Mikrotalkum ist.

## Claims

1. A process for the production of a protective mask by application of a thin layer of a coating composition to a printed circuit board by the curtain coating method, subsequent drying image-wise exposure excluding the soldered junctions subsequent development of the unexposed areas with a solvent and subsequent curing, which process comprises the use of a coating composition having a viscosity of 200 to 700 mPa.s at 25°C and comprising a solution of a photosensitive and thermally curable lacquer-forming substance, wherein the solution contains 10 to 50% by weight, based on the photosensitive substance of a finely particulate filler in uniform distribution and wherein the photosensitive and thermally curable substance is a photosensitive and thermally curable epoxide resin and the solution additionally contains a hardener.

2. A process according to claim 1, which has a viscosity in the range from 200 to 500 mPa.s.

3. A process according to claim 1 which contains an organic solvent.

4. A process according to claim 1 which contains 10 to 30 °/% by weight of the filler.

5. A process according to claim 1, wherein the filler has a mean particle size of 0.01 to 10 μm.

6. A process according to claim 1 wherein the filler is a micronised filler having a mean particle size of 0.01 to 1.5 μm

7. A process according to claim 1, which contains a filler selected from the group consisting of : finely particulate silica, micronised talcum, micronised mica, kaolin, aluminium oxide, aluminium hydroxide, calcium silicate, aluminium silicate, magnesium carbonate, calcium carbonate, zirconium silicate, porcelain powder, antimony trioxide, titanium dioxide, barium titanate of barium sulfate, or a mixture of said fillers.

8. A process according to claim 1, which contains at least 10% by weight of micronised talcum, either alone or in admixture with further finely particulate fillers, with at least hall of the total amount of filler being micronised talcum.

**Revendications**

1. Procédé de préparation de masques protecteurs par application d'une couche mince d'un produit de revêtement sur un circuit imprimé d'après le procédé de coulée en rideau, puis séchage, éclairage de formation d'images à l'exception des endroits des soudures, puis développement, à l'aide d'un solvant, des régions non éclairées et durcissement subséquent, procédé caractérisé en ce qu'on utilise un produit pour revêtement ayant une viscosité de 200 à 700 mPa.S à 25°C, formé d'une solution d'une substance génératrice d'un vernis thermodurcissable et photosensible, produit caractérisé en ce que, dans la solution, 10 a 50 °% en poids, par rapport à la substance photosensible, d'une charge en fines particules sont répartis de façon homogène, la substance thermodurcissable et photosensible est une résine époxyde thermodurcissable et photosensible et la solution contient en outre un durcisseur.

2. Procédé selon la revendication 1, caractérisé en ce que la viscosité se situe entre 200 et 500 mPa.s.

3. Procédé selon la revendication 1, caractérisé en ce qu'il contient un solvant organique.

4.Procédé selon la revendication 1, caractérisé en ce qu'il contient 10 à 30 % en poids de la charge.

5. Procédé selon la revendication 1, caractérisé en ce que la charge présente une grosseur moyenne des particules de 0,01 à 10 μm.

6. Procédé selon la revendication 1, caractérisé en ce qu'il contient comme charge une charge micronisée ayant une grosseur moyenne des particules de 0,01 à 1,5 μm.

7. Procédé selon la revendication 1, caractérisé en ce qu'il contient comme charge du dioxyde de silicium en fines particules, du micro talc, du micro mica, du kaolin, des oxydes de l'aluminium, de l'hydroxyde d'aluminium, du silicate de calcium, du silicate d'aluminium, du carbonate de magnésium, du carbonate de calcium, du silicate de zirconium, de la farine de porcelaine, du trioxyde d'antimoine, du dioxyde de titane, du titanate de baryum ou du sulfate de baryum ou des mélanges de ces charges.

8. Procédé selon la revendication 1, caractérisé, en ce qu'il contient au moins 10% en poids du micro talc seul ou en mélange avec d'autres charges en fines particules, la moitié au moins de la quantité totale de la ou des charges étant constituée du micro talc.